# FASCICULE DE BREVET EUROPEEN

(11) **EP 0 489 384 B1**
(45) Date de publication et mention de la délivrance du brevet: **15.03.1995**
(21) Numéro de dépôt: 91120661.3
(22) Date de dépôt: 02.12.1991
(51) Int. Cl.: H05K 1/18, H05K 3/36

(54) **Procédé d'orientation d'au moins un composant électronique placé sur une carte de circuit imprimé**
Verfahren zur Orientierung mindestens eines auf einer Leiterplatte aufgesetzten elektronischen Bauelementes
Method for orienting at least one electronic component placed on a printed circuit board

(30) Priorité: 06.12.1990 FR 9015313
(43) Date de publication de la demande: 10.06.1992
(73) Titulaire: MOULINEX, F-93170 Bagnolet (FR)
(72) Inventeur: Boin, Bernard, F-50000 Saint-Lô (FR); Lebedel, Philippe Benard Michel, F-50000 Saint-Lô (FR); Bellier, Denis Christian Henri, F-50000 Saint-Lô (FR)
(74) Mandataire: May, Hans Ulrich, Dr.

(56) Documents cités:
- FR-A- 2 626 999
- GB-A- 2 061 623
- GB-A- 2 160 366

## Description

L'invention concerne le domaine des cartes de circuits imprimés et plus particulièrement un procédé d'orientation d'au moins un composant électronique placé sur une carte de circuit imprimé.

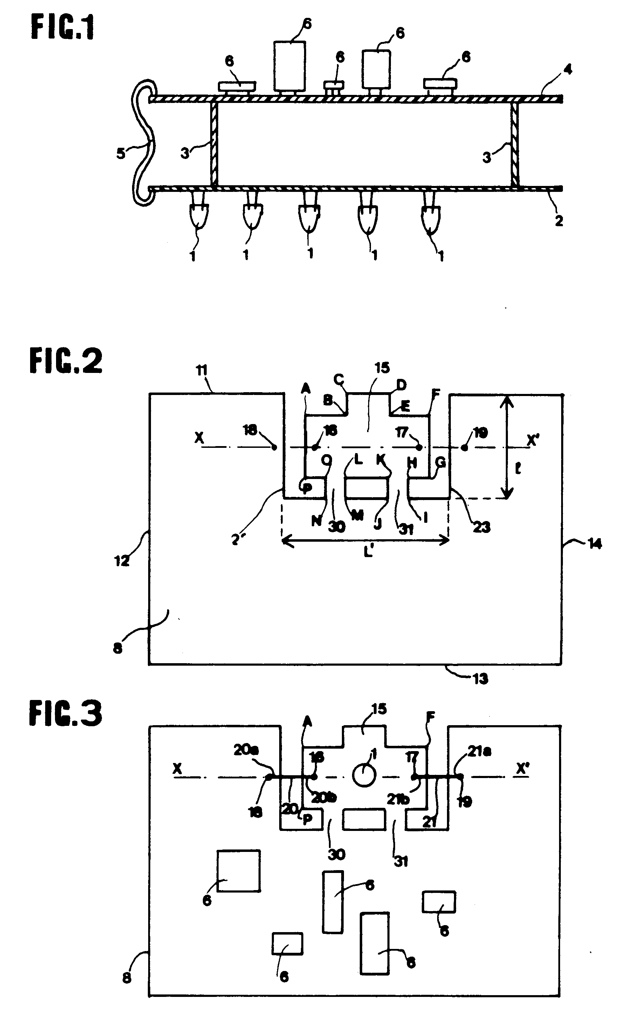

Les cartes de circuits imprimés comportent généralement une plaque isolante comprenant deux faces. La première face permet une impression linéaire, par exemple par sérigraphie, de pistes conductrices et la deuxième face assure la réception des composants électroniques qui sont connectés aux pistes conductrices de la première face par l'intermédiaire de trous métallisés réalisés dans la plaque isolante. Dans des applications particulières, par exemple lors de l'utilisation d'une carte de circuit imprimé dans un four micro-ondes, ladite carte de circuit imprimé ne peut supporter tous les composants sur la même face. En effet, pour visualiser les états de fonctionnement du four micro-ondes sur le tableau d'affichage servant à l'utilisateur, des voyants lumineux sont utilisés. Dans un tel cas, la carte de circuit imprimé doit être plaquée contre la face interne du boîtier placée sur la face avant du four micro-ondes. Cette opération n'est pas réalisable du fait notamment de l'épaisseur de certains composants, ainsi, une adaptation doit être effectuée. Comme le montre la figure 1, les voyants lumineux 1 sont montés sur une première carte 2 de circuit imprimé, cette dite carte est fixée par des éléments de fixation 3 sur une deuxième carte de circuit imprimé 4 qui contrôle le fonctionnement du four micro-ondes et sur laquelle sont fixés des composants électroniques 6. Les éléments de fixation sont, par exemple, au nombre de quatre, ce nombre étant nullement limitatif. La première carte 2 de circuit imprimé est reliée électriquement à la deuxième carte de circuit imprimé 4 par des fils de connexion 5. La connexion entre chacune des cartes de circuit imprimé est réalisée à la périphérie de chacune desdites cartes. Les voyants lumineux 1 de la première carte de circuit imprimé 2 et les composants électroniques 6 de la deuxième carte de circuit imprimé 4 sont sur les faces extérieures des deux cartes de circuit imprimé placées en vis à vis. De cette manière, les voyants lumineux 1 de la première carte de circuit imprimé 2 peuvent être plaqués à l'emplacement déterminé sur la face avant du boîtier du four micro-ondes. Le système ainsi utilisé, est encombrant, difficile à réaliser et coûteux.

Le document GB-A-2061623 décrit un procédé selon le préambule de la revendication 1.

Le but de l'invention est de mettre en oeuvre un procédé alternatif d'orientation d'au moins un composant électronique d'une portion de carte de circuit imprimé, qui soit rapide à fabriquer et économique.

Le procédé selon l'invention est défini dans la revendication 1.

Grâce à ce procédé, un espace important est libéré. En effet, l'utilisation d'une simple carte de circuit imprimé, sur laquelle des composants électroniques sont placés de part et d'autre, diminue considérablement l'épaisseur de l'emplacement utile. D'autre part, ce procédé augmente la fiabilité de la carte de circuit imprimé équipée de composants électroniques en limitant le nombre de connexion, et assure une simplification de réalisation qui diminue ainsi le prix de revient du système réalisé.

Les caractéristiques et avantages de l'invention ressortiront d'ailleurs de la description qui va suivre, à titre d'exemple, en référence aux dessins annexés dans lesquels :
- la figure 1 représente deux cartes de circuit imprimé utilisées dans l'art antérieur pour positionner des composants de part et d'autre d'une surface ;
- la figure 2 représente la pré-découpe d'une carte de circuit imprimé selon le procédé de l'invention ;
- la figure 3 représente la carte de circuit imprimé découpée selon l'invention sur laquelle sont positionnés les composants électroniques ;
- la figure 4 représente une autre réalisation de l'invention ; et
- la figure 5 représente la carte de circuit imprimé selon l'invention dont la portion prédécoupée a été retournée.

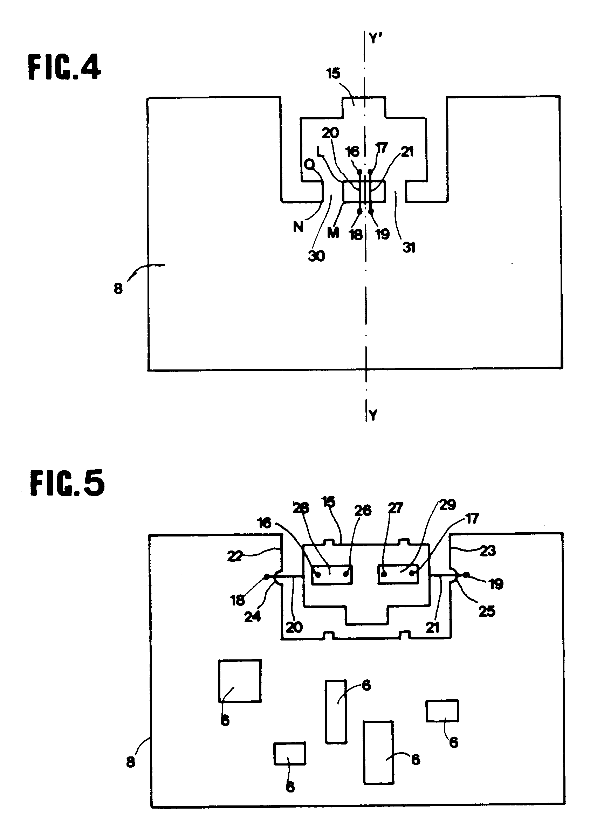

Selon la figure 2, une carte de circuit imprimé, selon l'invention, comporte une plaque isolante 8. La plaque isolante 8 est, par exemple, rectangulaire et comporte quatre côtés 11, 12, 13, et 14. Un des côtés 11 de la plaque 8 comporte une pré-découpe 15, chacun des côtés (11 ou 12 ou 13 ou 14) pouvant comporter plusieurs pré-découpes. La pré-découpe 15 correspond à une portion de la carte de circuit imprimé qui supporte, après implantation des composants, un composant électronique, par exemple, un voyant lumineux 1 ; ladite portion de carte peut supporter également plusieurs composants électronique. Cette portion 15 est pré-découpée sur une longueur L′ et une largeur 1 correspondant respectivement à la longueur et à la largeur maximum de pré-découpe sur la carte de circuit imprimé. La forme de cette portion 15 est, par exemple, rectangulaire. D'autres formes de pré-découpe, par exemple, circulaires ou carrées peuvent être réalisées. La portion pré-découpée 15 est maintenue à la carte de circuit imprimé, par exemple, par deux sections fragilisables 30 et 31 dont une des caractéristiques principales est de résister à la cassure lors de l'implantation des composants électroniques. Dans l'exemple de réalisation décrit, les sections fragilisables sont au nombre de deux mais leur nombre peut être une ou plusieurs, l'exigence essentielle étant une résistance adaptée pour, d'une part, éviter la cassure lors de l'implantation des composants électroniques et, d'autre part, rompre facilement lors du retournement de la portion pré-découpée 15 sous l'action d'une force obtenue, par exemple, par une pince.

La portion de carte de circuit imprimé 15 de forme rectangulaire est délimitée par un segment AA comportant quatre sections AF, FG, GP et PA. La section AF comprend deux parties plates AB et EF parallèles à la périphérie des côtés 11 et 13 et une partie pleine rectangulaire BCDE dont les côtés BC et DE sont parallèles aux côtés 12 et 14 et les côtés CD et BE sont parallèles aux côtés 11 et 13. Les sections FG et PA sont parallèles aux côtés 12 et 14. La section GP comprend trois parties plates GH, KL et NP, et deux parties pleines rectangulaires HIJK et LMNO dont les côtés HI, JK, LM et NO sont parallèles aux côtés 11 et 13. Le positionnement des parties rectangulaires HIJK et LMNO correspondant aux deux sections fragilisables 30 et 31 ainsi que les dimensions de ces dites parties déterminent le positionnement et les dimensions de la partie pleine rectangulaire BCDE. En effet, pour éviter, lors de la rotation de la portion de carte de circuit imprimé, qu'une partie de la portion de carte de circuit imprimé vienne heurter les tronçons de sections fragilisables restant après cassure desdites sections, les parties destinées à venir en regard desdits tronçons doivent être creuses c'est-à-dire absence de matière (non représentées sur la Figure) ou plates comme les parties AB et EF. C'est ainsi que la partie pleine rectangulaire BCDE a une longueur CD inférieure à la longueur KL et une largeur BC inférieure à la largeur LM.

La portion rectangulaire pré-découpée 15 sur laquelle sont imprimées des pistes conductrices comporte également deux points de contact 16 et 17 ; ces points de contact 16 et 17 sont, par exemple, des trous métallisés réalisés dans la plaque isolante 8 et en liaison directe avec les pistes conductrices réalisées sur la portion 15 et figurant sur l'autre face non représentée de la plaque isolante 8. Deux autres points de contact 18 et 19 sont réalisés sur la carte de circuit imprimé sur les côtés 22 et 23 ; ces points de contacts sont, par exemple, des trous métallisés réalisés dans la plaque isolante 8 et en liaison directe avec les pistes conductrices de la carte de circuit imprimé. L'ensemble des points de contact 16, 17, 18 et 19 est positionné, par exemple, sur un seul axe XX′. Sur la figure 3, une carte de circuit imprimé comportant une plaque isolante 8 et pré-découpée selon l'invention, est représentée après implantation des composants électroniques 6 y compris un voyant lumineux 1 que l'on appellera "led" dans la suite de la description et positionné sur la portion 15 pré-découpée. D'autre part pour relier électriquement la portion 15 et la carte de circuit imprimé 8, deux fils électriques 20 et 21 ayant chacun deux extrémités sont implantés respectivement entre les points de contact 16 et 17 de la portion 15 et les points de contact 18 et 19 de la carte de circuit imprimé 7. Une extrémité 20a du fil électrique 20 est reliée au point de contact 18 de la carte de circuit imprimé 7 et l'autre extrémité 20b du dit fil 20 est reliée au point de contact 16 de la portion de carte de circuit imprimé 15. L'extrémité 21a du fil électrique 21 est relié au point de contact 19 de la carte de circuit imprimé 8 et l'autre extrémité 21b dudit fil 21 est reliée au point de contact 17 de la portion 15. Les points de contact 16 et 17 de la portion de carte de circuit imprimé 15 sont implantés respectivement à la demi-longueur des parties PA et FG et les points de contact 18 et 19 de la carte de circuit imprimé 8 sont implantés en vis-à-vis des points de contact 16 et 17 pour que l'ensemble des points de contact soit aligné. La position des points de contact 16, 17, 18 et 19 est déterminée pour que la portion 15 puisse tourner librement, après rupture des sections fragilisables 30 et 31 autour de l'axe XX′.

La position des points de contact décrit dans l'exemple de réalisation n'est pas limitative. En effet, l'invention consiste à faire pivoter une portion de carte de circuit imprimé autour d'au moins un axe, cet axe étant soit parallèle aux côtes OL et MN d'au moins une section fragilisable, soit perpendiculaire aux côtés ON et LM de cette même section. Dans ce dernier cas, comme le montre la Figure 4, pour autoriser une libre rotation, sachant qu'il existe deux fils électriques 20 et 21 reliant la portion 15 de carte de circuit imprimé à la carte de circuit imprimé 8, les points de contact 16 et 17 de la portion 15 et les points de contact 18 et 19 de la carte de circuit imprimé sont positionnés en vis à vis à une distance déterminée, de préférence faible, de manière à ce que les segments (16, 18) et (17, 19) comportant les fils électriques 20 et 21 soient sensiblement confondus avec un axe YY′ parallèle, par exemple, aux côtes ON et LM de la section fragilisable 30.

Après cassure des sections fragilisables 30 et 31, la portion 15 peut pivoter autour des fils électriques 20 et 21 pratiquement confondues avec l'axe YY′. Dans ce cas, les deux fils électriques 20 et 21 s'entrelacent et, pour éviter tout risque de court-circuit, ces deux fils électriques 20 et 21 sont isolés.

D'autre part, pour que la portion 15 de la carte de circuit imprimé 7, après rotation comme représenté à la figure 5, soit située, dans un exemple d'application, dans le même plan que la carte de circuit imprimé, des découpes 24 et 25, de forme quelconque par exemple circulaire, sont pratiquées sur la carte de circuit imprimé sur les côtés 22 et 23 supportant également les points de contact 18 et 19. Sur la figure 5, la led 1 n'apparaît plus, par contre les pattes de fixation 26 et 27 de cette led sont fixées respectivement aux pistes conductrices 28 et 29 de la portion 15 reliant ainsi électriquement le composant électronique de la portion 15 à la carte de circuit imprimé 8. Les découpes 24 et 25 sont situées sur l'axe XX′ et permettent, lors du retournement de la portion 15 après rupture des sections fragilisables 30 et 31, à chacun des deux fils électriques 20 et 21 de se couder pour que la portion de la carte de circuit imprimé 15 n'est pas une position décalée par rapport au plan de la carte de circuit imprimé 8.

Dans un exemple d'application particulier non représenté, il est possible aussi d'orienter un composant électronique dans une direction déterminée. En effet, la portion 15 de la carte de circuit imprimé 8 tourne dans l'exemple décrit d'un angle α égale à 180° mais cet angle α n'est pas limitatif ; l'angle α est compris dans un intervalle I défini par 0° < α < 360°, et une position, où la portion 15 fait, avec la carte de circuit imprimé 8, un angle α égale à 90°, peut être intéressante dans une application industrielle particulière.

D'autres exemples de réalisations pourraient être décrits. De nombreuses formes de portion 15, par exemple circulaires ou carrées, ainsi que des zones de pré-découpe de ces portions, par exemple un positionnement au milieu d'une carte, peuvent être réalisées les seules exigences à respecter étant un alignement des points de contact sensiblement sur un même axe, une pré-découpe de la portion avec des dimensions de la portion pré-découpée inférieure à la pré-découpe sur la carte de circuit imprimé et un positionnement des points de contact de manière à ce que la portion de la carte de circuit imprimé ne heurte pas la carte de circuit imprimé lors de la rotation de la portion 15.

Le procédé selon l'invention s'applique aux cartes de circuit imprimé montées sur les fours à micro-ondes mais il peut s'appliquer à tout dispositif nécessitant un retournement de composants électroniques sur une carte de circuit imprimé.

## Revendications

1. Procédé d'orientation d'au moins un composant électronique placé sur une carte de circuit imprimé comportant une plaque isolante (8) comprenant deux faces, une première face sur laquelle sont réalisées des pistes conductrices et une deuxième face sur laquelle sont implantés des composants électroniques reliés aux pistes conductrices par des trous métallisés pratiqués dans la plaque isolante (8), le procédé consistant:
- à pré-découper au moins une portion (15) sur la carte de circuit imprimé, cette portion (15) étant maintenue à la carte par au moins une section fragilisable (30 ou 31) suffisamment rigide pour éviter toute rupture lors de l'implantation des composants électroniques sur ladite portion (15) ainsi que sur la carte de circuit imprimé;
- à implanter des composants électroniques (6) sur la carte et la portion (15) par encastrement dans des trous et à relier électriquement, par des fils électriques (20 et 21), plusieurs points de contact (18, 19) situés sur la carte de circuit imprimé à plusieurs autres points de contact (16, 17) situés sur la portion (15) pré-découpée, lesdits points de contact (16, 17) situés sur la portion (15) et les points de contact (18, 19) situés sur la carte de circuit imprimé constituant des paires (16,18;17,19) de points de contact, lesdits paires étant alignés selon des axes parallèles de manière à autoriser une libre pivotement de la portion (15) autour d'un axe;
- à passer la carte de circuit imprimé, supportant les composants électroniques, à la soudure à la vague pour réaliser le soudage des composants électroniques sur les pistes conductrices de la carte de circuit imprimé et de la portion;
- à rompre au moins la section fragilisable (30 ou 31); et
- à faire pivoter d'un angle (α) la portion de la carte de circuit imprimé de manière à orienter au moins un composant électronique implanté sur ladite portion, dans une position déterminée différente de la position initiale;
**caractérisé en ce que** les points de contact (18, 19) situés sur la carte de circuit imprimé sont au nombre de deux et les points de contact (16,17) situés sur la portion (15) pré-découpée sont au nombre de deux et en ce que ces dites paires (16,18;17,19) de points de contact sont positionnés en fonction de la longeur (L′) et la largeur (l) pré-découpées et sensiblement sur un même axe, de manière à autoriser une libre rotation de la portion (15) autour de cet axe.

2. Procédé d'orientation selon la revendication 1, caractérisé en ce que la portion (15) de la carte de circuit imprimé à une forme rectangulaire et comporte deux sections fragilisables (30 et 31).

3. Procédé d'orientation selon la revendication 2, caractérisé en ce que le composant électronique de la portion de carte de circuit imprimé est un voyant lumineux (1).

4. Procédé d'orientation selon la revendication 1 caractérisé en ce que l'angle α est sensiblement égal à 180°.

5. Procédé d'orientation selon la revendication 1, caractérisé en ce que les quatre points de contact (16, 17, 18, 19) sont alignés selon un axe (XX′) sensiblement parallèle à l'un des côtés de la plaque.

6. Procédé d'orientation selon la revendication 1, caractérisé en ce que les quatre points de contact sont alignés deux à deux et positionnés à proximité d'un axe (YY′).

## Patentansprüche

1. Verfahren zur Orientierung mindestens eines elektronischen Bauteils, das auf eine Karte einer gedruckten Schaltung gesetzt wird, welche eine Isolierplatte (8) mit zwei Seiten aufweist, nämlich eine erste Seite, auf der Leiterbahnen ausgebildet sind, und eine zweite Seite, auf der elektronische Bauteile eingesetzt sind, die mit den Leiterbahnen durch in der Isolierplatte (8) ausgebildete metallisierte Bohrungen verbunden sind, wobei das Verfahren aus folgenden Schritten besteht:
- es wird mindestens ein Teil (15) auf der Karte der gedruckten Schaltung durch Vorab-Ausschnitt gebildet, wobei dieser Teil (15) an der Karte durch mindestens einen zerbrechbaren Abschnitt (30 oder 31) gehalten ist, der genügend starr ist, um jeden Bruch beim Einsetzen der elektronischen Bauteile auf dem Teil (15) sowie auf der Karte der gedruckten Schaltung zu vermeiden;
- elektronische Bauteile (6) werden auf der Karte und dem Teil (15) durch Einführung in Bohrungen eingesetzt und durch elektrische Drähte (20 und 21) werden mehrere auf der Karte der gedruckten Schaltung gelegene Kontaktpunkte (18, 19) mit mehreren anderen, auf dem vorab ausgeschnittenen Teil (15) gelegenen Kontaktpunkten (16, 17) verbunden, wobei diese auf dem Teil (15) liegenden Kontaktpunkte (16, 17) und die auf der Karte der gedruckten Schaltung liegenden Kontaktpunkte (18, 19) Paare (16,18; 17,19) von Kontaktpunkten bilden und diese Paare längs paralleler Achsen ausgerichtet sind, um eine freie Schwenkung des Teils (15) um eine Achse zu ermöglichen;
- die Karte der gedruckten Schaltung, welche die Elektronik-Bauteile trägt, wird Lötbadwellen ausgesetzt, um die Elektronik-Bauteile an die Leiterbahnen der Karte der gedruckten Schaltung und des Teils (15) anzulöten;
- es wird mindestens der zerbrechbare Abschnitt (30 oder 31) zerbrochen; und
- der Teil der Karte der gedruckten Schaltung wird um einen Winkel (α) gedreht, um mindestens einen auf dem Teil eingesetzten Elektronik-Bauteil in eine von der Anfangsstellung verschiedene bestimmte Stellung zu orientieren;
**dadurch gekennzeichnet**, daß die Anzahl der auf der Karte der gedruckten Schaltung liegenden Kontaktpunkte (18, 19) zwei beträgt und die Anzahl der auf dem vorab ausgeschnittenen Teil (15) gelegenen Kontaktpunkte (16, 17) zwei beträgt und daß die Paare (16,18; 17,19) von Kontaktpunkten in Abhängigkeit von der Länge (L′) und der Breite (l), die vorab ausgeschnitten wurden, und im wesentlichen auf ein und derselben Achse so angeordnet sind, daß eine freie Drehung des Teils (15) um diese Achse ermöglicht wird.

2. Verfahren zur Orientierung nach Anspruch 1, **dadurch gekennzeichnet**, daß der Teil (15) der Karte der gedruckten Schaltung eine rechteckige Form hat und zwei zerbrechbare Abschnitte (30 und 31) aufweist.

3. Verfahren zur Orientierung nach Anspruch 2, **dadurch gekennzeichnet**, daß der elektronische Bauteil des Teils der Karte der gedruckten Schaltung eine Leuchtanzeige (1) ist.

4. Verfahren zur Orientierung nach Anspruch 1, **dadurch gekennzeichnet**, daß der Winkel α im wesentlichen gleich 180° ist.

5. Verfahren zur Orientierung nach Anspruch 1, **dadurch gekennzeichnet**, daß die vier Kontaktpunkte (16, 17; 18,19) in Richtung einer Achse (XX′) ausgerichtet sind, die im wesentlichen zu einer der Seiten der Platte parallel ist.

6. Verfahren zur Orientierung nach Anspruch 1, **dadurch gekennzeichnet**, daß die vier Kontaktpunkte paarweise in einer Linie liegen und in der Nähe einer Achse (YY′) angeordnet sind.

## Claims

1. Method of orienting at least one electronic component placed on a printed circuit board having an insulating sheet (8) comprising two sides, a first side on which conductive tracks are produced and a second side on which are installed electronic components connected to the conductive tracks by plated holes made in the insulating sheet (8), the method consisting of:
- pre-cutting at least one portion (15) on the printed circuit board, this portion (15) being held on the board by at least one frangible section (30 or 31) which is sufficiently rigid to avoid any breakage on installation of the electronic components on the said portion (15) and on the printed circuit board;
- installing the electronic components (6) on the board and the portion (15) by flush-mounting in holes, and electrically connecting, with electrical wires (20 and 21), several contact points (18, 19) situated on the printed circuit board to several other contact points (16, 17) situated on the pre-cutout portion (15), the said contact points (16, 17) situated on the portion (15) and the contact points (18, 19) situated on the printed circuit board constituting pairs (16, 18; 17, 19) of contact points, the said pairs being aligned along parallel axes so as to allow free pivoting of the portion (15) around an axis;
- subjecting the printed circuit board supporting the electronic components to wave soldering to achieve the soldering of the electronic components onto the conductive tracks of the printed circuit board and the portion;
- breaking at least the frangible section (30 or 31); and
- causing the portion of the printed circuit board to pivot through an angle (α) so as to orientate at least one electronic component installed on the said portion, in a given position different from the initial position;
characterised in that the contact points (18, 19) situated on the printed circuit board are two in number and the contact points (16, 17) situated on the pre-cutout portion (15) are two in number and in that these said pairs (16, 18; 17, 19) of contact points are positioned according to the pre-cutout length (L′) and width (l) and substantially on the same axis, so as to allow free rotation of the portion (15) around this axis.

2. Method of orientation according to claim 1, characterised in that the portion (15) of the printed circuit board has a rectangular shape and has two frangible sections (30 and 31).

3. Method of orientation according to claim 2, characterised in that the electronic component of the portion of printed circuit board is an indicator lamp (1).

4. Method of orientation according to claim 1, characterised in that the angle α is substantially equal to 180°.

5. Method of orientation according to claim 1, characterised in that the four contact points (16, 17, 18, 19) are aligned along an axis (XX′) substantially parallel to one of the edges of the sheet.

6. Method of orientation according to claim 1, characterised in that the four contact points are aligned in pairs and positioned near to an axis (YY′).
